# EUROPÄISCHE PATENTANMELDUNG

(11) **EP 4 764 514 A1**
(43) Veröffentlichungstag der Anmeldung: **24.06.2026**
(21) Anmeldenummer: 25224535.2
(22) Anmeldetag: 17.12.2025
(51) Int. Cl.: G01R 31/08, G01R 31/52

(54) **MESSGERÄT ZUM DETEKTIEREN VON DURCH EINEN KABELFEHLER HERVORGERUFENEN MESSSIGNALEN**

(30) Priorität: 20.12.2024 AT 1852024
(71) Anmelder: BAUR GmbH, 6832 Sulz (AT)
(72) Erfinder: Bawart, Manfred, 6832 Sulz (AT)
(74) Vertreter: Torggler & Hofmann Patentanwälte - Rankweil

(57) **Zusammenfassung**

Messgerät (1) zum Detektieren von durch einen Kabelfehler (2) und/oder Mantelfehler (3) hervorgerufenen Messsignalen (4) in der Umgebung des Kabels (5), wobei das Messgerät (1) zumindest zwei Elektroden (6) umfasst, welche dazu ausgebildet sind, die Messsignale (4), vorzugsweise direkt im Erdbereich (7), abzunehmen, wobei das Messgerät (1) zum Ausführen der folgenden Funktionen ausgebildet ist:
- Entgegennehmen eines, vorzugsweise mittels der zumindest zwei Elektroden (6) abgenommenen, ersten Messsignals (4a) und
- Generieren eines Synchronisationssignals (8), welches mit dem ersten Messsignal (4a) zeitlich und/oder in einer Phasenlage synchron ist, und
- Auswerten eines mittels der Elektroden (6) abgenommenen zweiten Messsignals (4b) und/oder nachfolgenden Messsignals (4c) synchron mit dem Synchronisationssignal (8) (Fig. 1).

## Beschreibung

Die vorliegende Erfindung betrifft ein Messgerät zum Detektieren von durch einen Kabelfehler und/oder Mantelfehler hervorgerufenen Messsignalen in der Umgebung des Kabels, wobei das Messgerät zumindest zwei Elektroden umfasst, welche dazu ausgebildet sind, die Messsignale, vorzugsweise direkt im Erdreich, abzunehmen.

Messgeräte sind unerlässlich für die Überwachung und Sicherheit von Nieder,- Mittel- und Hochspannungsnetzen sowie industriellen Anlagen. Sie erkennen Erdschlüsse, also ungewollte Verbindungen zwischen einem Leiter und der Erde, und verhindern so Ausfälle, Spannungs- und Energieverluste und Brandgefahren. Zur Erkennung nutzen die Geräte meist Strom- und Spannungsmessungen wie die Nullstrom- und Nullspannungsmessung, um Abweichungen bei Erdströmen und Erdspannung aufzuspüren.

Aus dem Stand der Technik geht ein Messgerät hervor, wie ein Kabelfehler detektiert werden kann.

Die DE 10 2021 124 432 A1 offenbart ein Messgerät zum Detektieren eines erdfühligen Fehlers in einem Niederspannungskabelnetz mit einem Adapter zum elektrischen Verbinden mit einem Niederspannungskabelnetz. Beim Stand der Technik ist somit notwendig, eine Funksynchronisation beziehungsweise einen Adapter bereitzustellen.

Die DE 10 2010 035 882 A1 zeigt eine Vorrichtung zur Ortung eines Erdschlusses an einem im Erdreich verlegten Stromversorgungskabel. Sie umfasst eine Einrichtung zur Beaufschlagung des Kabels mit einer "Wechselspannung bestimmter Polarität" und eine Auswerteinrichtung zur Analyse der Schrittspannung. Die Auswerteinrichtung ermittelt, welcher der beiden Abgriffe näher zum Erdschluss liegt.

Die DE 10 2012 017 869 B4 zeigt eine Vorrichtung zur Reduzierung von Störsignalen. Sie umfasst einen Signaleingang, einen Signalausgang und eine Korrektureinheit. Am Eingang liegt ein Signal an, das ein Sendesignal und ein Störsignal enthält, wobei das Sendesignal ein gepulstes Gleichspannungssignal ist. Die Korrektureinheit ermittelt automatisch ein Korrektursignal, das entweder dem Eingangssignal aufprägt oder ein Nutzsignal erzeugt, das dann am Ausgang bereitgestellt wird.

Aufgabe der Erfindung ist es, ein Messgerät genannter Art und/oder ein Verfahren zum Detektieren von durch einen Kabelfehler hervorgerufenen Messsignalen in der Umgebung des Kabels und/oder ein Computerprogrammprodukt dahingehend zu verbessern, dass das Detektieren von Kabelfehlern effektiver unterstützt werden kann, insbesondere indem auf einen zusätzlichen Adapter und/oder Einspeisung einer Fremdspannung / Signalspannung / gepulste Gleichspannung und / oder einen Stationszugang sowie auf die Freischaltung des Kabels verzichtet werden kann.

Hierfür schlägt die Erfindung gemäß Anspruch 1 vor, dass das Messgerät zum Ausführen der folgenden Funktionen ausgebildet ist:
- Entgegennehmen eines, vorzugsweise mittels der Elektroden abgenommenen, ersten Messsignals und
- Generieren eines Synchronisationssignals, welches mit dem ersten Messsignal zeitlich und/oder in einer Phasenlage synchron ist, und
- Auswerten eines mittels der Elektroden abgenommenen zweiten Messsignals und/oder nachfolgenden Messsignals synchron mit dem Synchronisationssignal.

Unter dem synchronen Auswerten des zweiten Messsignals und/oder nachfolgenden Messsignalen mit dem Synchronisationssignal kann verstanden werden, dass das zweite Messsignal und/oder nachfolgenden Messsignalen auf wie auch immer geartete Weise bezüglich der Phasenlage mit dem Synchronisationssignal verglichen wird. Es wird also ausgewertet, ob und/oder bis zu welchem Grad das zweite Messsignal und/oder nachfolgende Messsignale synchron mit dem Synchronisationssignal ist/sind.

Das Synchronisationssystem, welches zum Erzeugen des Synchronisationssignals bevorzugt Teil des Messgeräts ist, kann auch als Zeitsynchronisationssystem bezeichnet werden und kann dazu ausgebildet sein, das Synchronisationssignal zu generieren.

Weiteres kann ausgewertet werden, bis zu welchem Grad das zweite Messsignal synchron und in gleicher Phasenlage und/oder Polarität mit dem Synchronisationssignal ist.

Der Begriff "Umgebung" beschreibt einen weiten Definitionsbereich und kann demnach ebenso den Bereich im Spannungstrichter beschreiben und/oder ebenso den Bereich an der Erdoberfläche entlang des im Erdreich verlegten Kabels beschreiben.

Das Messgerät kann ein Erdschlussdetektionsgerät und/oder ein Mantelfehlerortungsgerät umfassen.

Es kann sein, dass das erste Messsignal und/oder zweite Messsignal und/oder das nachfolgende Messsignal, vorzugsweise alle Messsignale, direkt mit dem Synchronisationssignal im Messgerät abgeglichen werden.

Eine Funksynchronisation, das mit technisch aufwendiger Synchronisation und sehr kurzer und wiederholbar stabiler Latenzzeit einhergeht, ist sohin obsolet, weil die Messsignale wie beschrieben direkt mit dem Synchronisationssystem im Messgerät ausgewertet beziehungsweise abgeglichen werden können.

Erfindungsgemäß ist vorgesehen, dass das erste Messsignal mittels der zumindest zwei Elektroden entgegengenommen werden kann.

Die Elektroden werden in der Fachsprache mitunter auch als Schrittspannungs-Elektroden, Schrittspannungssonden oder Erdspieße bezeichnet.

Es ist denkbar, dass die Messsignale alternativ zu den zumindest zwei voneinander separaten Elektroden ebenso mittels eines A-Rahmens entgegengenommen werden können, in welchen die zumindest zwei Elektroden integriert sind.

Es kann sein, dass die Messsignale über kapazitive Elektroden entgegengenommen werden.

Es kann wie erwähnt sein, dass der A-Rahmen zumindest zwei Elektroden aufweisen kann. Sollte eine größere Abgriffsdistanz gewünscht sein, ist es ebenso denkbar, an den A-Rahmen zumindest eine zusätzliche (externe) Elektrode anzuschließen.

Die Elektroden sind zum Abnehmen von Messsignalen aus einem Untergrund, vorzugsweise direkt einem Erdreich, ausgebildet.

Es kann sein, dass es sich beim Kabel um ein Mittelspannungskabel oder Hochspannungskabel oder Höchstspannungskabel, vorzugsweise um ein Niederspannungskabel, handelt.

Am Kabel liegt bevorzugt Wechselspannung an, sodass die hierin erwähnten Signale dann im Wesentlichen alternierende und/oder periodische Signale sein werden.

Es kann sein, dass das Messgerät im Zusammenhang mit einem Niederspannungsnetz, insbesondere bei ungeschirmten Kabeln, ein Erdschlussdetektionsgerät umfasst.

Es kann sein, dass das Messgerät im Zusammenhang mit einem Mittelspannungsnetz und/oder Hochspannungsnetz und/oder Höchstspannungsnetz, insbesondere bei geschirmten Kabeln, ein Mantelfehlerortungsgerät umfasst.

Zusätzlich oder alternativ zum Schrittspannungssignal kann ein magnetfeldbasiertes Signal zur Feststellung der Kabellage, zur Feststellung des axialen Versatzes zum Kabel und/oder als weitere Methode zur Bestätigung des Kabelfehlers eingesetzt werden.

Hierbei ist es möglich, dass die Magnetfeldaufnahme des Kabelfehlers mittels zumindest eines Sensors, bevorzugt mittels eines Magnetfeldsensors, Hallsensors oder einer Suchspule, basierend auf einer Wechselstromfrequenz ermittelt wird.

Weiteres kann es zusätzlich sein, dass bei Überschreiten des Kabelfehlers, das Magnetfeld um den Kabelfehler mittels eines oder mehrerer eindimensionalen und/oder zweidimensionalen und/oder dreidimensionalen Sensors beziehungsweise Sensoren ermittelt wird.

Mit einem entsprechend ausgestalteten Sensor zur Erfassung zumindest einer Komponente eines Magnetfelds kann für zumindest eines der folgenden eingesetzt werden:
- Magnetische Ortung mit gleichzeitiger Trassenbestimmung (durch Bestimmung von axialem Versatz zum Kabel)
- Koinzidenzmessung:
   synchronisierte Schrittspannungsortung kombiniert mit gleichzeitiger Magnetfeldortung zur Fehlerortsbestimmung

Der Vollständigkeit halber wird darauf hingewiesen, dass im Zuge der Beschreibung dieser Erfindung die verwendeten Zahlwörter wie ein, zwei, drei und dergleichen, grundsätzlich nur die vorhandene Mindestmenge eines Merkmals des erfindungsgemäßen Messgerät beschreiben. Einzelne Merkmale oder Bestandteile des Messgeräts können natürlich auch in größerer Anzahl vorhanden sein. In diesem Sinne ist zum Beispiel das Zahlwort ein im Sinne von mindestens ein usw. zu verstehen.

Es ist also denkbar, dass die zumindest zwei Elektroden fix mit dem Messgerät ausgebildet sind oder auch jederzeit, vorzugsweise zerstörungsfrei, lösbar sind. Es ist also möglich, dass die zumindest zwei Elektroden bei Defekten und/oder anderen Bedürfnissen ausgetauscht werden können.

Es kann sein, dass neben dem ersten Messsignal auch ein zweites oder drittes oder viertes usw. Messsignal detektiert werden kann.

Es kann also sein, dass die Annäherung an den Kabelfehler beginnend mit einem ersten Messsignal weiterverfolgt wird, indem mehrere Messsignale, vorzugsweise in Richtung zum Fehler, detektiert werden.

Es kann sein, dass beim Auswerten aller Messsignale ein Phasenabgleich des jeweiligen Messsignals, insbesondere des nachfolgenden Messsignals, mit dem Synchronisationssignal erfolgt.

Es kann sein, dass additiv überlagerte Spannungen die Messung bzw. das Detektieren des Kabelfehlers und/oder Mantelfehlers beeinträchtigen. Es kann sein, dass dabei exponentiell abfallende transiente Störungen auftreten, welche beispielsweise durch das Einstechen der zumindest zwei Elektroden in die Erdoberfläche verursacht werden. Diese Transiente kann um ein Vielfaches größer sein als die zu messende Wechselspannung.

Es kann sein, dass das Messgerät zur Reduzierung von einem Messsignal additiv überlagerten Störsignalen beim Detektieren von Kabelfehlern und/oder Mantelfehlern ausgebildet ist.

Es kann sein, dass das Messgerät einen Signaleingang, einen Signalausgang und/oder eine Korrektureinheit aufweist, wobei am Signaleingang das Eingangssignal (bspw. in Form des ersten Messsignals, des zweiten Messsignals oder weiterer Messsignale) anliegt, welches eine additive Überlagerung eines Messsignals mit einem Störsignal, insbesondere einem transienten Störsignal oder einer überlagerten Gleichspannung, ist.

Es kann sein, dass die "Korrektureinheit" eine elektrische Schaltung umfasst, welche automatisch das am Signaleingang anliegende Eingangssignal um das Störsignal "bereinigt".

Insbesondere kann die Korrektureinheit eine FPGA-Schaltung oder eine Mikrocontroller-Schaltung aufweisen, welche jeweils mit entsprechend eingerichteter Software- oder Hardware-Realisierung eines Korrekturalgorithmus ausgestattet sind.

Ein "Korrektursignal" ist insbesondere ein mittels Korrektureinheit Signal, welches von dem Eingangssignal "subtrahiert" wird, sodass idealerweise das additive Störsignal eliminiert ist.

Im idealen Fall entspricht das Korrektursignal dem Störsignal. Unter Subtrahieren im vorliegenden Falle fällt auch ein Herausfiltern des Störsignals, sodass das eigentliche Nutzsignal verbleibt.

Weiterhin kann die Korrektureinheit eine Gleichspannungsanteilsmesseinheit aufweisen, insbesondere ein Medianfilter, und den geschätzten Gleichspannungsanteil dem Eingangssignal zur Eliminierung aufprägen.

Es kann somit eine Vorrichtung zur Mantelfehlerortung bereitgestellt werden, welche direkt eine obige Korrektureinrichtung aufweist, sodass direkt und automatisch beim Lokalisieren eines Mantelfehlers und/oder Kabelfehlers Korrekturen an den Messsignalen erfolgen.

Es kann sein, dass zur Vermeidung von Fehlmessungen eine Schaltanordnung zur Ermittlung des Gleichspannungsanteils eingesetzt wird.

Die Schaltungsordnung kann dabei den Gleichspannungsanteil bewerten und kompensieren und/oder korrigieren, automatisch und/oder gleichzeitig oder zeitversetzt in Bezug auf das Gleichspannungsstörsignal. Es ist weiters denkbar, dass die Kompensation des Gleichspannungsanteils auch durch ein selbstlernendes System trainiert wird.

Es kann sein, dass der Benutzer ein vorbestimmtes Phasenwinkelprofil zur Auswertung verwendet, um Störgeräusche beziehungsweise Störeinflüsse von anderen im Erdreich angeordneten Kabeln und/oder metallischen Leitungen zu filtern.

Durch einen Frequenzfilter ist es möglich, Störsignale zu unterdrücken.

Speziell im Bereich von Photovoltaikanlagen und/oder Ladestationen für Elektrofahrzeuge und/oder von niederfrequenten AC-Spannungen, beispielsweise durch eine Bahntrasse hervorgerufen, kann eine Unterdrückung von Störsignalen eine wichtige Rolle spielen.

In anderen Worten kann es sein, die Störsignale messtechnisch "herauszufiltern".

Als "Störsignal" werden insbesondere Signale gewertet, welche additiv das Sendesignal überlagern.

Insbesondere sind transiente Signale umfasst, wie sie insbesondere beim Einstecken von den zumindest zwei Elektroden ins Erdreich entstehen.

Es ist weiters denkbar, dass der Frequenzfilter neben eines manuell bereitgestellten Phasenwinkelprofils auch durch ein selbstlernendes System trainiert wird.

In anderen Worten ist es also denkbar, dass der Frequenzfilter zumindest einen Algorithmus für maschinelles Lernen aufweist, mit dem dieser seine Filterung von unerwünschten Frequenzen trainiert.

Es kann sein, dass das Messgerät dazu ausgebildet ist, mehr als ein Viertel, bevorzugt mehr als die Hälfte, bevorzugt 3/4, besonders bevorzugt mehr als 90% einer Vollperiode des ersten periodischen Messsignals und/oder des zweiten periodischen Messsignals, vorzugsweise aller periodischer Messsignale, auszuwerten.

Es kann sein, dass beliebig eingestellt werden kann, welcher Anteil einer Phase eines Messsignals ausgewertet wird.

Alternativ oder zusätzlich zur Auswertung der jeweiligen Messsignale mittels eines Phasenabgleichs der jeweiligen Sinuskurven kann es sein, dass die Auswertung der jeweiligen Messsignale mittels einer mathematischen Methode, vorzugsweise mittels einer Hüllkurvenbestimmung oder einer Fourier Transformation, erfolgt.

Es kann sein, dass das erste Messignal und/oder das zweite Messsignal und/oder nachfolgenden Messsignals, vorzugsweise alle Messsignale, eine Spannung und/oder eine Stromstärke umfasst beziehungsweise umfassen.

Es kann sein, dass die Spannung eine Schrittspannung ist.

Der Begriff "Schrittspannung" beschreibt eine elektrische Spannung, die zwischen zwei Erdungspunkten auftritt, die durch den Abstand eines durchschnittlichen Schrittes voneinander getrennt sind.

Es ist denkbar, dass die Schrittspannung eine unterschiedliche Schrittlänge aufweist.

Es ist denkbar, dass auch der Abstand zwischen der zumindest zwei Elektroden unterschiedlich einstellbar ist.

Das Messsignal kann eine Schrittspannung sein und findet man typischerweise nahe am Kabelfehler, da das Potentialgefälle hier am stärksten ist.

Im vorliegenden Fall kann es so verstanden werden, dass die zwei Punkte für die Schrittspannung an der Erdoberfläche in einem Abstand der Schrittlänge voneinander getrennt sind.

Es kann sein, dass das Messgerät dazu ausgebildet ist, die Wechselspannung und/oder die Frequenz des ersten Messsignals und/oder des zweiten Messsignals, vorzugsweise aller Messsignale, zu ermitteln.

Es kann sein, dass das Messgerät dazu ausgebildet ist, das Synchronisationssignal kontinuierlich weiter zu generieren, falls das Messsignal unterbrochen wird.

Eine Unterbrechung des Messsignals kann beispielsweise dann auftreten, wenn eine der zumindest zwei Elektroden gehoben wird und an einer anderen Position entlang der Erdoberfläche in das Erdreich gesteckt wird.

Das Synchronisationssignal wird hierbei trotz der Unterbrechung des Messsignals weiter generiert.

Das Generieren des Synchronisationssignals kann mittels einer automatischen Frequenzeinhaltung, vorzugsweise mit der Benutzung eines Taktsignals oder eines internen Frequenzzählers, und zeitlicher Überbrückung, der Nullbereiche erfolgen.

Der Begriff "Benutzung eines Taktsignals" beschreibt ein Verfahren, bei dem der richtige zeitliche Ablauf einer elektrischen Schaltung, vorzugsweise einer digitalen Schaltung, sichergestellt werden kann.

Es kann sein, dass das Messgerät dazu ausgebildet ist, während des Entgegennehmens des ersten Messsignals und/oder des zweiten Messsignals und/oder der nachfolgenden Messsignale, vorzugsweise während aller Messsignale, eine Synchronisierung der Phasenlage und/oder der Frequenz und/oder des Spannungspegels auf das vom Messgerät generierten Synchronisationssignal durchzuführen.

Es kann bevorzugt vorgesehen sein, dass das Messgerät dazu ausgebildet ist, das Synchronisationssignal mit dem ersten Messsignal und/oder dem zweiten Messsignal und/oder dem nachfolgenden Messsignal, vorzugsweise mit allen Messsignalen, hinsichtlich der Phasenlage und/oder der Frequenz und/oder des Spannungspegels zu synchronisieren, vorzugsweise unter Verwendung einer kontinuierlichen Frequenzüberwachung und/oder einer automatischen Frequenznachführung.

Es kann sein, dass eine automatische Nachsynchronisierung der Frequenz bei einem Frequenzdrift erfolgt.

Es ist möglich, dass der Frequenzdrift über einen definierten Zeitraum hinweg analysiert werden kann. Der Zeitraum kann im Sekundenbereich und/oder im Minutenbereich und/oder auf eine Periodenanzahl, bevorzugt zwischen 100 Perioden und 10000 Perioden, besonders bevorzugt zwischen 1000 Perioden und 10000 Perioden, festgelegt sein.

Es ist möglich, eine Abweichung des Phasenwinkelprofils in einem Bereich von 10 bis 20 Grad, bevorzugt im Bereich von 5 bis 10 Grad, festzustellen.

Es ist möglich mit einer kontinuierlichen adaptiven Regelung die Synchronisation entsprechend der aktuellen Netzfrequenz anzupassen.

Der Begriff "Frequenzdrift" beschreibt eine Veränderung der Frequenz eines Signals, das zur Fehlerdiagnose oder Überwachung von Kabeln und elektrischen Systemen verwendet wird. Eine Drift kann beispielsweise auftreten, wenn sich die Frequenz eines Wechselstroms beziehungsweise der Wechselspannung innerhalb eines Kabels, über die Zeit hinweg verändert wird.

Es kann auch sein, dass der Bediener die Nachjustierung der Frequenz manuell durchführen kann. Es ist weiters denkbar, dass die Frequenz-Nachjustierung durch ein selbstlernendes System trainiert wird.

Es kann sein, dass das Messgerät dazu ausgebildet ist, eine Polaritätsumkehr zwischen dem ersten und zweiten Messsignals und/oder nachfolgenden Messsignals, vorzugsweise zwischen aller Messsignale, zu erfassen.

Der Begriff "Polaritätsumkehr" beschreibt eine Änderung des Vorzeichens eines Messsignals. Eine Polaritätsumkehr kann somit eine Änderung der Signalrichtung bedeuten. Im vorliegenden Fall kann das Vorzeichen für die Interpretation von Messwerten wichtig sein.

Es kann sein, dass das Messgerät dazu ausgebildet ist, einen erhaltenen zweiten Betrag eines Spannungspegels des detektierten zweiten Messsignals mit einem erhaltenen ersten Betrag eines ersten Spannungspegels des detektierten ersten Messsignals zu vergleichen.

Der Begriff "Spannungspegel" kann beispielsweise als Maximum des Absolutwertes der gemessenen Spannung verstanden werden.

Der Spannungspegel ergibt sich im Rahmen von Kabel- oder Mantelfehlern aus der Spannungsverteilung im Untergrund, die auch als Spannungstrichter bezeichnet werden kann. Der Spannungstrichter beschreibt bei Kabelfehlern die durch den Kabelfehler verursachte Spannung, die sich in der Umgebung des Fehlers und/oder entlang des Erdreichs ausbreitet. Direkt beim Kabelfehler kann eine hohe Spannung vorhanden sein.

Die Messung des Spannungspegels kann mittels der zumindest zwei Elektroden erfolgen, indem sie in einem definierten Abstand voneinander von etwa 0,5 bis 2 Meter, bevorzugt 0,8 bis 1 Meter, positioniert werden.

Die Messung des Spannungspegels kann mittels des A-Rahmen erfolgen, bei dem der definierte Elektrodenabstand im Bereich von 0,2 bis 1,5 Meter, bevorzugt im Bereich von 0,4 bis 1,0 Meter sein kann.

Es kann sein, dass das Messgerät dazu ausgebildet ist, einen höheren Betrag des Spannungspegels des zweiten Messsignals (oder weiteren Messsignals) zum Betrag des Spannungspegels des detektierten ersten Messsignals (vorherigen, bevorzugt unmittelbar vorherigen, Messignals), bevorzugt unter Berücksichtigung der Phasenlage, zu vergleichen und/oder zu interpretieren, dass der Kabelfehler, während der Messung des zweiten Messsignals (weiteren Messsignals) näher an den zumindest zwei Elektroden gelegen ist als bei der Messung des ersten Messsignals (vorherigen, bevorzugt unmittelbar vorherigen, Messignals).

Es kann sein, dass das Messgerät dazu ausgebildet ist, einen niedrigeren Betrag des Spannungspegels des zweiten Messsignals (oder weiteren Messsignals) zum Betrag des Spannungspegels des detektierten ersten Messsignals (vorherigen, bevorzugt unmittelbar vorherigen, Messignals), bevorzugt unter Berücksichtigung der Phasenlage, zu vergleichen und/oder zu interpretieren, dass der Kabelfehler, während der Messung des zweiten Messsignals (weiteren Messsignals) weiter von den zumindest zwei Elektroden gelegen ist als bei der Messung des ersten Messsignals (vorherigen, bevorzugt unmittelbar vorherigen, Messsignals).

In anderen Worten kann es bedeuten, dass bei einem geringeren Betrag des Spannungspegels des zweiten Messsignals die zumindest zwei Elektroden, insbesondere die zweite Messung, weiter vom Kabelfehler entfernt sind als während der ersten Messung.

Es kann also sein, dass bei der vorliegenden Erfindung durch das Synchronisieren eine Richtungserkennung des Kabelfehlers ermöglicht wird.

Es ist denkbar, dass die Richtungserkennung mittels einer Richtungsanzeige über ein Display, das im Messgerät, insbesondere im Mantelfehlerortungsgerät und/oder Erdschlussdetektionsgerät integriert sein kann, angezeigt wird.

Es ist ebenso denkbar, dass die Richtungserkennung mittels einer akustischen Richtungsanzeige angezeigt wird.

Es kann sein, dass das Messgerät einen integrierten Lautsprecher zur Ausgabe eines akustischen Signals aufweist. Es kann aber ebenso sein, dass an das Messgerät ein externer Lautsprecher oder Kopfhörer angeschlossen wird, um so ein akustisches Signal abzugeben. Die Signalübertragung an den Kopfhörer kann auch Kabellos erfolgen.

Es kann also sein, dass eine wiederholte Messung, also eine Messung eines dritten Messsignals oder eine Messung eines vierten Messsignals etc., und ein erneuter Vergleich der jeweiligen Beträge der Spannungspegel des jeweiligen Messsignals notwendig ist, um herauszufinden, wo der Kabelfehler lokalisiert ist.

Ganz besonders bevorzugt kann es dabei sein, dass das jeweils zuletzt aufgenommene Messsignal, insbesondere das zweite Messsignal und/oder die nachfolgenden Messsignale, synchron mit dem Synchronisationssignal ausgewertet wird.

Alles im Rahmen der vorliegenden Offenbarung in Verbindung mit dem ersten Messsignal und dem zweiten Messsignal offenbarte gilt analog für das vorletzte Messsignal und das zuletzt aufgenommene Messsignal, vorzugsweise für alle Messsignale.

Es ist aber weiteres denkbar, die Koordinaten in ein dreidimensionales Koordinatensystem zu übertragen, bevorzugt unter Zuhilfenahme von GPS-Koordinaten der einzelnen Messungen.

Es kann sein, dass das Messgerät dazu ausgebildet ist, die erhaltenen Messdaten des ersten Messsignals und/oder des zweiten Messsignals und/oder nachfolgenden Messsignals, vorzugsweise aller Messsignale, und/oder einen Spannungspegel und/oder eine Richtungsangabe visuell oder akustisch auszugeben.

Es ist möglich, die Verlaufshistorie der jeweiligen Messungen und/oder der Spannungspegel und/oder der Richtungsangaben visuell oder akustisch auszugeben.

Es ist also denkbar, dass das Messgerät einen integrierten Bildschirm oder ein integriertes Display oder einen integrierten Touchscreen aufweist, der die erhaltenen Messdaten visualisiert.

Es ist, wie erwähnt, ebenso denkbar, dass die Richtungserkennung mittels einer akustischen Richtungsanzeige angezeigt wird.

Es ist aber ebenso möglich, dass das Messgerät einen Anschluss oder eine Schnittstelle aufweist, über den ein externer Monitor oder ein Tablet oder ein Laptop angeschlossen werden kann. Die Datenübertragung kann dabei auch kabellos erfolgen.

Es ist denkbar, dass der integrierte Bildschirm des Messgeräts die jeweiligen Messsignale in einer farbigen und/oder schwarzweiß Darstellung abbildet.

Es kann sein, dass das Messgerät dazu ausgebildet ist, während der Messung des ersten Messsignals und/oder zweiten Messsignals und/oder nachfolgenden Messsignals, vorzugsweise aller Messsignale, die Koordinaten mittels GPS-Ortung festzustellen.

Es ist möglich vordefinierte GPS-Koordinaten und/oder Kartendaten und/oder Kabelverlegedaten während der Messung aller Messsignale zu verwenden.

Es kann sein, dass das das Messgerät dazu ausgebildet ist, die mittels GPS-Ortung erhaltenen Koordinaten, vorzugsweise automatisch, in ein kartographisches System zu übertragen.

Ein zweites erfindungsgemäßes Ausführungsbeispiel zeigt ein Messgerät zum Detektieren von durch einen Kabelfehler und/oder Mantelfehler hervorgerufenen Messsignalen in der Umgebung des Kabels, bevorzugt nach einem der vorhergehenden Ansprüche wobei das Messgerät zumindest zwei Elektroden umfasst, welche dazu ausgebildet sind, die Messsignale, vorzugsweise direkt im Erdbereich, abzunehmen, dadurch gekennzeichnet, dass zusätzlich eine Referenzelektrode vorgesehen ist und das Messgerät zum Ausführen der folgenden Funktionen ausgebildet ist:
- Entgegennehmen eines mittels der Referenzelektrode abgenommenen Referenzsignals und
- Auswerten eines mittels der zumindest zwei Elektroden abgenommenen Messsignals und/oder nachfolgenden Messsignals synchron mit dem Referenzsignal.

Es kann sein, dass das Messgerät die Potentialdifferenz zwischen zumindest einer der zwei Elektroden und der Referenzelektrode ermitteln kann.

Neben der Erfindung als Messgerät an sich betrifft die Erfindung auch ein
Verfahren zum Detektieren von durch einen Kabelfehler hervorgerufenen Messsignalen in der Umgebung des Kabels, bevorzugt mittels eines Messgeräts umfassend die nachfolgenden Schritte:
- Aufnehmen eines, vorzugsweise mittels der zumindest zwei Elektroden abgenommenen, ersten Messsignals und
- Generieren eines Synchronisationssignals, welches mit dem ersten Messsignal zeitlich synchron ist, und
- Auswerten eines mittels der Elektroden abgenommenen zweiten Messsignals und/oder nachfolgenden Messsignals synchron mit dem Synchronisationssignal.

Neben einer zweiten erfindungsgemäßen Erfindung in Form eines Messgeräts an sich betrifft die Erfindung ein zweites erfindungsgemäßes Verfahren zum Detektieren von durch einen Kabelfehler und/oder Mantelfehler hervorgerufenen Messsignalen in der Umgebung des Kabels, bevorzugt mittels eines Messgeräts umfassend die nachfolgenden Schritte:
- Entgegennehmen eines mittels der Referenzelektrode abgenommenen Referenzsignals und
- Auswerten eines mittels der zumindest zwei Elektroden abgenommenen Messsignals und/oder nachfolgenden Messsignals synchron mit dem Referenzsignal.

Die Referenzelektrode ist dazu ausgebildet, das Referenzsignal aus einem Untergrund, vorzugsweise direkt aus einem Erdbereich abzunehmen.

In bevorzugten Ausführungsbeispielen kann es sein, dass die gesamte Phase des ersten Messsignals und/oder des zweiten Messsignals herangezogen wird. Es ist aber ebenso denkbar, dass nur Teile von einer Phase des ersten Messsignals und/oder des zweiten Messsignals herangezogen werden.

In anderen Worten kann das bedeuten, dass in bevorzugten Ausführungsbeispielen die negativen und die positiven Halbschwingungen verwendet werden.

Es ist ebenso denkbar, dass bei einem angepassten Funktionsprinzip die negativen oder die positiven Halbschwingungen verwendet werden.

Es kann sein, dass zumindest einer der Schritte, bevorzugt alle der Schritte, wiederholt werden können, falls eine Messung nicht erfolgreich war.

Weiteres ist denkbar, dass die Wiederholung auch der Verifizierung des jeweiligen Messsignals dienen kann.

Natürlich ist ebenso denkbar, dass nach Durchlaufen nach allen Schritten, bevorzugt nach jedem einzelnen Schritt, insbesondere bei einem Polaritätswechsel beziehungsweise einem Richtungswechsel, eine automatische Wiederholung des jeweiligen Schrittes beziehungsweise aller Schritte erfolgt.

Es ist aber auch denkbar, dass der Benutzer frei auswählen kann, welcher Schritt und/oder welche Schritte des Verfahrens wiederholt werden sollten.

Es kann sein, dass die einzelnen Schritte des Verfahrens manuell durch einen Bediener und/oder automatisch gestartet werden, wenn mit Hilfe der zumindest zwei Elektroden der Kabelfehler, insbesondere eine netzfrequente Schrittspannung, detektiert wird.

Es ist bevorzugt möglich, dass das Kabel während der Durchführung eines Verfahrens gemäß der vorliegenden Offenbarung und/oder der Fehlerbehebung weiterhin in Betrieb bleibt.

Als besonderer Vorteil bleiben die Hausanschlüsse während der Messung am Kabel, müssen also nicht abgeklemmt werden, denn in vielen Fällen ist ein Abklemmen nur durch Zutritt in die Häuser möglich.

Es kann sein, dass zum Detektieren von jedem weiteren Messsignal alle der Schritte zu wiederholen sind.

In anderen Worten kann es bedeuten, dass jeder der Verfahrensschritte auf alle weiteren Messsignale angewandt wird.

Es kann sein, dass das Messgerät dazu ausgebildet ist, das erste Messsignal und/oder das zweite Messsignal, vorzugsweise alle Messsignale und/oder nachfolgenden Messsignals, zeitversetzt und/oder ortsversetzt mittels der zumindest zwei Elektroden zu detektieren.

Es ist also möglich, dass sich die Zeitpunkte, an dem das erste Messsignal und/oder das zweite Messsignal, vorzugsweise alle Messsignale, detektiert werden, unterscheiden. Besonders bevorzugt wird das zweite Messsignal nach dem ersten Messsignal aufgenommen.

Es kann nicht ausgeschlossen werden, dass zur Detektion des Kabelfehlers mehrere Messungen, also mehrere Messsignale, notwendig sind.

Es kann sein, dass mehrere Fehlerstellen auf dem Kabel sind.

Es kann von Vorteil sein das Synchronisationssignal dreifach auszuführen mit jeweils 120 Grad Phasenverschiebung.

Dies erlaubt die Auswertung von weiteren Fehlersignalen und deren Zuweisung zu einer weiteren Phase oder Fehlerstelle.

Es ist ebenso möglich, dass sich der Ort beziehungsweise die Koordinaten, an dem das erste Messsignal und/oder das zweite Messsignal, vorzugsweise alle Messsignale, detektiert werden, unterscheiden.

Es kann weiteres sein, dass der Bediener frei darüber entscheiden kann, in welchen Zeitabständen die jeweiligen Detektionen des ersten Messsignals und/oder des zweiten Messsignals, vorzugsweise aller Messsignale, durchgeführt werden.

Die Schrittspannungsmessungen (im allgemeinen erstes Messsignal, zweites Messsignal, weitere Messsignale) erfolgen in Längsausrichtung zum Kabel, also entlang des Kabels. Im Fehlernahbereich erfolgt die Messung auch zusätzlich in Querrichtung um den Fehler in alle Richtungen einzugrenzen. Neben der Erfindung an sich betrifft die Erfindung auch die Verwendung des erfindungsgemäßen Messgeräts bei einem Verfahren gemäß der Erfindung.

Weiteres betrifft die vorliegende Erfindung ein Computerprogrammprodukt, umfassend Befehle, die bei der Ausführung des Programms durch Computer diesen veranlassen, folgendes durchzuführen:
- Entgegennehmen eines, vorzugsweise mittels der zumindest zwei Elektroden abgenommenen, ersten Messsignals,
- Generieren eines Synchronisationssignals, welches mit dem ersten Messsignal zeitlich synchron ist, und
- Auswerten eines mittels der Elektroden abgenommenen zweiten Messsignals und/oder nachfolgenden Messsignals synchron mit dem Synchronisationssignal.

Weiteres betrifft die vorliegende Erfindung ein zweites erfindungsgemäßes Computerprogrammprodukt, umfassend Befehle, die bei der Ausführung des Programms durch Computer diesen veranlassen, folgendes durchzuführen:
- Entgegennehmen eines mittels der Referenzelektrode abgenommenen Referenzsignals und
- Auswerten eines mittels der zumindest zwei Elektroden abgenommenen Messsignals und/oder nachfolgenden Messsignals synchron mit dem Referenzsignal.

Weiteres betrifft die vorliegende Erfindung ein transitorisches oder nicht transitorisches computerlesbares Speichermedium auf dem die oben erläuterten Computerprogrammprodukte gespeichert sind, oder zumindest eines davon.

Weitere Merkmale und Einzelheiten bevorzugter Ausgestaltungsformen der Erfindungen werden exemplarisch in der nachfolgenden Figurenbeschreibung erläutert. Es zeigen:
- Fig. 1:: eine Darstellung eines Messvorgangs bei Kabelfehlern mittels des Messgeräts;
- Fig. 2:: eine Darstellung des Messvorgangs gem. Fig. 1;
- Fig. 3:: eine Darstellung zu einem ersten Ausführungsbeispiel mit einem ungeschirmten mehrpoligen Kabel;
- Fig. 4:: eine Darstellung im Schnitt A-A eines Kabels gem. Fig. 3;
- Fig. 5:: eine Darstellung zu einem zweiten Ausführungsbeispiel mit einem geschirmten Kabel;
- Fig. 6:: eine Darstellung im Schnitt B-B eines Kabels gem. Fig. 5;
- Fig. 7:: eine Darstellung zu Messvorgängen mit Synchronisierung;
- Fig. 8:: eine Darstellung zu Messvorgängen ohne Synchronisierung;
- Fig. 9:: ein Blockdiagramm;
- Fig. 10:: eine Darstellung eines Messsignals;
- Fig. 11:: eine detaillierte Darstellung zur Auswertung des ersten Messvorgangs gem. Fig. 7.

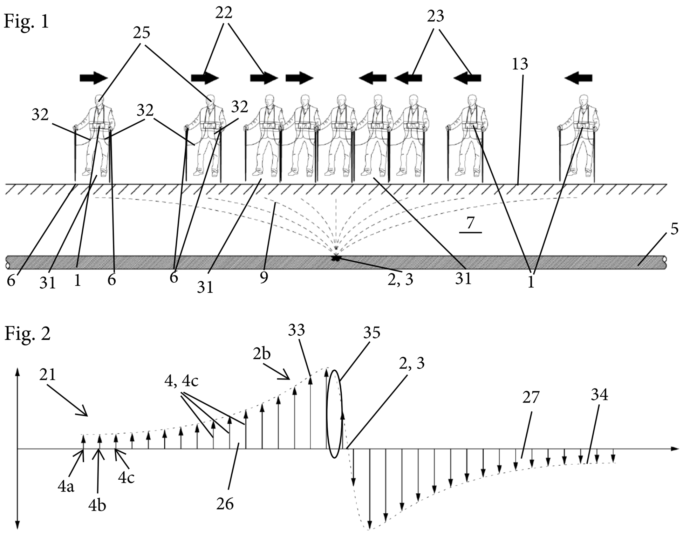

Fig. 1 zeigt eine Darstellung eines Messvorgangs bei Kabelfehlern 2 und/oder Mantelfehlern 3 mittels des Messgeräts 1.

Fig. 1 zeigt eine Übersicht des Messvorgangs, insbesondere wie der Benutzer 25 mit dem Messgerät 1 entlang der Erdoberfläche 13 an verschiedenen Positionen 31 mit den zumindest zwei Elektroden 6 den Kabelfehler 2 und/oder Mantelfehler 3 eines Kabels 5 auffindet.

Es ist natürlich denkbar, dass das Kabel 5 mehr als einen Kabelfehler 2 und/oder Mantelfehler 3 hat.

Es kann sein, dass das Messgerät 1 ein Erdschlussdetektionsgerät und/oder ein Mantelfehlerortungsgerät umfasst.

Es kann sein, dass es sich beim Kabel 5 um ein ungeschirmtes Kabel oder um ein geschirmtes Kabel handelt. Wenn es sich beim Kabel 5 ein ungeschirmtes Kabel handelt, so ist es möglich, dass das Messgerät 1 ein Erdschlussdetektionsgerät umfasst oder ist.

Wenn es sich beim Kabel 5 um ein geschirmtes Kabel handelt, dann ist es möglich, dass das Messgerät 1 ein Mantelfehlerortungsgerät umfasst oder ist.

Fig. 1 zeigt, dass die zumindest zwei Elektroden 6 mit dem Messgerät 1 jeweils über Verbindungskabel 32 miteinander verbunden sind. Es ist also denkbar, dass die zumindest zwei Elektroden 6 fix mit dem Messgerät 1 sind oder auch jederzeit, vorzugsweise zerstörungsfrei, lösbar sind.

Bevorzugt sind die zumindest zwei Elektroden 2 mit dem Messgerät über Verbindungkabel 32 verbunden, wobei diese Verbindungskabel 32 mittels einer Steckverbindung an das Messgerät 1 anschließbar sein können.

Fig. 1 veranschaulicht, dass für das Detektieren eines Kabelfehlers 2 und/oder Mantelfehlers 3 mehrere Messungen und demnach mehrere Messsignale 4 notwendig sein können.

Es ist denkbar, dass jede Position 31 eine Messung abbildet und somit ein (erstes, zweites, weiteres) Messsignal 4 liefert.

Wie bereits oben erwähnt, zeigt Fig. 1, dass mittels der zumindest zwei Elektroden 6 das Kabel 5 vom Benutzer 25 entlang der Erdoberfläche 13 auf Kabelfehler 2 und/oder Mantelfehler 3, insbesondere Schrittspannungssignale 20, abgeschritten wird.

Es ist denkbar, dass bei Detektion eines Messsignals 4 das Messgerät 1 dazu ausgebildet ist, die Wechselspannung und/oder die Frequenz des ersten Messsignals 4a und/oder des zweiten Messsignals 4b und/oder der nachfolgenden Messsignale 4c zu ermitteln.

Der Vollständigkeit halber wird darauf hingewiesen, dass im Zuge dieser Figurenbeschreibung unter dem "nachfolgenden Messsignal" jedes Messsignal nach dem zweiten Messsignal gemeint sein kann.

Weiteres wird darauf hingewiesen, dass der Begriff Messsignal 4 das erste Messsignal 4a und/oder das zweite Messsignal 4b und/oder alle Messsignale und/oder das nachfolgende Messsignal 4c umfasst.

Der Vollständigkeit halber wird darauf hingewiesen, dass im Zuge der Beschreibung dieser Erfindung die verwendeten Zahlwörter wie ein, zwei, drei und dergleichen, grundsätzlich nur die vorhandene Mindestmenge eines Merkmals des erfindungsgemäßen Messgeräts 1 beschreiben.

Es ist denkbar, dass in einem Ausführungsbeispiel dieser Erfindung die Messsignale 4 anstatt der zumindest zwei Elektroden 6 mittels eines A-Rahmens (nicht in den Figuren gezeigt) entgegengenommen werden können.

Fig. 1 zeigt, dass an einer Position 31 ein erstes Messsignal 4a mittels der zumindest zwei Elektroden 6 entgegengenommen wird.

Beim Einstechen der zumindest zwei Elektroden 6 ins Erdreich 7 kann es sein, dass teilweise transiente Störungen entstehen.

Diese Störspannungen bewirken eine additive Überlagerung zum Messsignal 4, sodass sich ein gestörtes Eingangssignal ergibt.

Es kann vorgesehen sein, dass das gestörte Eingangssignal durch Filtern oder Subtrahieren der Störung in Form der additiven Überlagerung verbessert wird.

Bei Erkennen des ersten Messsignals 4a ist denkbar, dass neben der Ermittlung der Frequenz und/oder der Wechselspannung auch ein Phasenabgleich des jeweiligen Messsignals 4, insbesondere des nachfolgenden Messsignals, mit dem Synchronisationssignal 8 erfolgt.

Weiteres kann es sein, dass hierbei auch eine Polaritätsumkehr zwischen dem ersten Messsignal 4a und zweiten Messsignals 4b und/oder nachfolgenden Messsignals 4c, vorzugsweise zwischen aller Messsignale, erfasst wird.

Es ist denkbar, dass das Messgerät 1 Informationen zur Messung, insbesondere zur Polaritätsumkehr, in anderen Worten zur Richtungserkennung, vorzugsweise über ein integriertes Display und/oder einen integrierten Touchscreen anzeigen kann und/oder ein akustisches Signal über einen Lautsprecher und/oder über Kopfhörer abgeben kann und so dem Benutzer 25 bereitgestellt wird, wann ein Messsignal 4 detektiert wurde und/oder wann das Messgerät 1 für die nächste Messung bereit ist.

Für die zweite Messung und/oder dritte Messung und/oder nachfolgende Messung ist denkbar, dass die zumindest zwei Elektroden 6 angehoben werden, um an einer anderen Position 31 entlang des Kabels an der Erdoberfläche 13 eine Messung durchführen zu können.

Wenn die zumindest zwei Elektroden 6 an einer anderen Position 31 entlang der Erdoberfläche 13 des Erdreichs 7 gesteckt wird, ist denkbar, dass die nächste Messung startet. Durch das Anheben der zumindest zwei Elektroden 6 kann es sein, dass das Messsignal 4 unterbrochen wird, weshalb jetzt das jeweils zuletzt aufgenommene Messsignal 4 synchron mit dem Synchronisationssignal 8 ausgewertet wird.

Es kann sein, dass das Messgerät 1 dazu ausgebildet ist, einen erhaltenen zweiten Betrag eines Spannungspegels 9 des detektierten zweiten Messsignals 4b mit einem erhaltenen ersten Betrag eines Spannungspegels 9 des detektierten ersten Messsignals 4a zu vergleichen.

Es kann sein, dass das Messgerät 1 bei einem Vergleich Informationen bezüglich der Gehrichtung, insbesondere einer ersten Richtung 22 und/oder einer zweiten Richtung 23, dem Benutzer 25 zur Verfügung stellt. Dies beschreibt in anderen Worten die Richtungserkennung, im Rahmen derer festgestellt wird, ob sich der Benutzer 25 zum Kabel- oder Mantelfehler hin oder weg bewegt.

Wenn sich der Benutzer 25 genau über dem Kabelfehler 2 und/oder Mantelfehler 3 befindet, kann es sein, dass sich die Spannungsgradienten ausgleichen, weshalb keine Messsignale gemessen werden.

Erfindungsgemäß ist vorgesehen, dass das Messgerät 1 das Synchronisationssignal 8, welches mit dem ersten Messsignal 4a zeitlich und/oder in einer Phasenlage synchron ist, generiert, und ein mittels der zumindest zwei Elektroden 6 abgenommenes zweites Messsignal 4b und/oder nachfolgendes Messsignal 4c synchron mit dem Synchronisationssignal 8 auswertet.

Der oben beschriebene Messvorgang wird für jedes Messsignal 4 wiederholt.

Mit dem vorliegenden Ausführungsbeispiel kann erkannt werden, ob der Benutzer 25 den Kabel- oder Mantelfehler überschritten hat oder nicht, dies wird in Verbindung mit Fig. 2 näher erläutert.

Fig. 2 zeigt ein erstes Diagramm 21, insbesondere ein Spannungs-Weg-Diagramm mit Richtungserkennung, das den Verlauf des oben beschriebenen Messvorgangs grafisch darstellt.

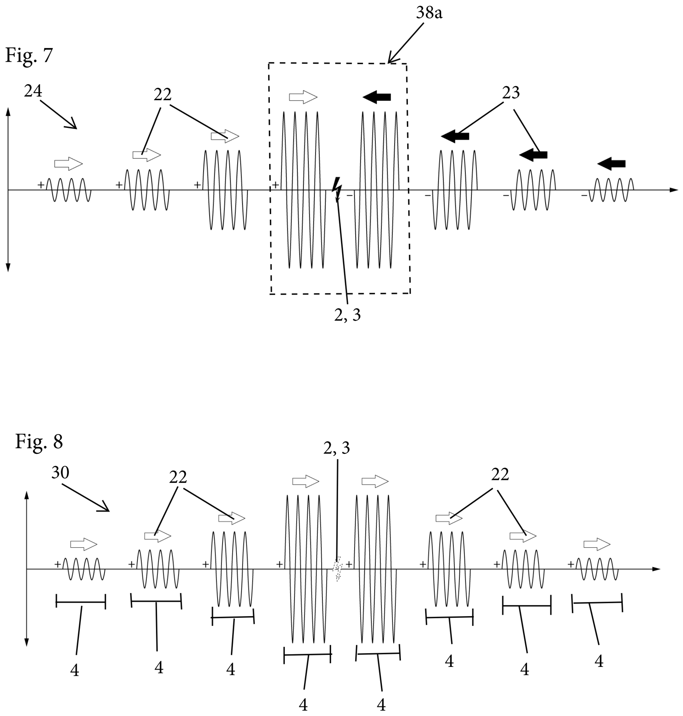

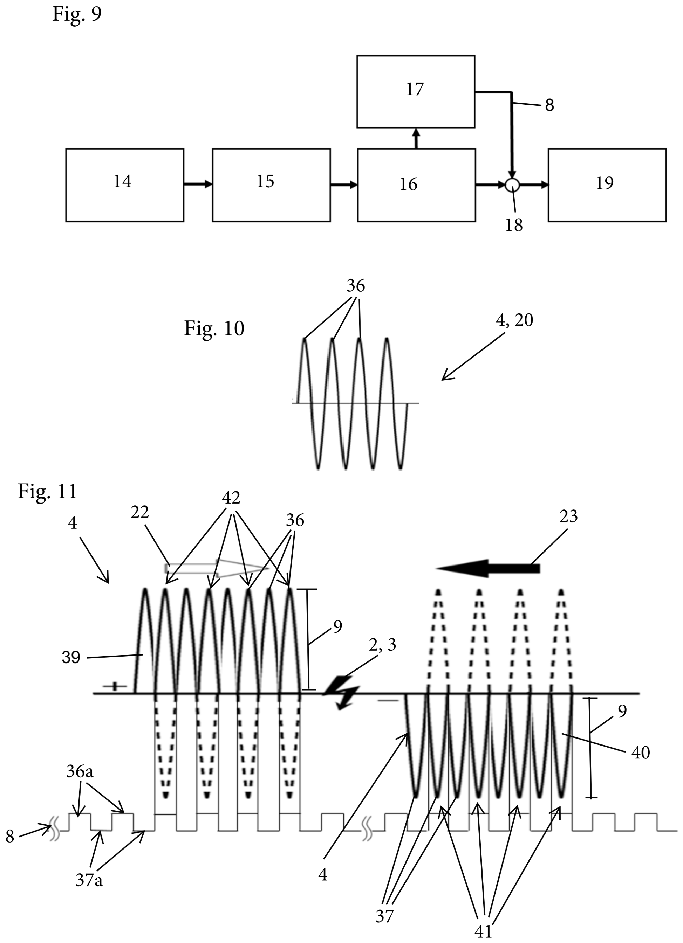

Die y-Achse des ersten Diagramms 21 zeigt den Spannungspegel (jeweils visualisiert als Pfeil), der jeweils aus den einzelnen Messsignalen 4 (siehe Fig. 7 und 11) bestimmt wird. Die x-Achse des ersten Diagramms 21 zeigt den Weg.

Das Vorzeichen des jeweiligen Pfeils (also ob er nach oben oder unten weist) bestimmt sich durch die Polarität des Messsignals 4 in Bezug auf das Synchronisationssignal 8.

Bei der ersten Messung (erstes Messsignal 4a) wird das Synchronisationssignal 8 erzeugt (siehe Fig. 11), beispielsweise in Form einer Rechteckspannung in Phase mit dem ersten Messsignal.

Das nächste aufgenommene Messsignal 4b wird hinsichtlich der Phasenlage mit dem Synchronisationssignal 8 abgeglichen. Ist es in Phase mit dem Synchronisationssignal wird von der gleichen Polarität ausgegangen und es wird angenommen, dass der Kabel- oder Mantelfehler nicht überschritten wurde. Im Detail wird dies in Verbindung mit den Fig. 7, 8 und 11 erläutert.

Anhand des zweiten Messsignals 4b kann das Synchronisationssignal überprüft und gegebenenfalls adaptiert werden, beispielsweise durch eine leichte Phasenkorrektur.

Das Messgerät 1 ist in diesem Ausführungsbeispiel dazu ausgebildet, das Synchronisationssignal mit dem ersten dem zweiten Messsignal 4b und/oder nachfolgenden Messsignalen 4/4c, hinsichtlich der Phasenlage und/oder der Frequenz zu synchronisieren, vorzugsweise unter Verwendung einer kontinuierlichen Frequenzüberwachung mit einer automatischen Frequenznachführung.

Bei der nächsten Messung (Messsignal 4c) wird wieder überprüft, ob die Polarität jene des Synchronisationssignals ist oder nicht und gegebenenfalls das Synchronisationssignal angepasst oder neu generiert. Weiters wird der Anstieg des Spannungsbetrags zur vorhergehenden Messung überprüft. Dies wird für die weiteren Messungen wiederholt.

Der Benutzer 25 wird sich für die weiteren Messungen so bewegen, dass sich der Spannungspegel erhöht. Bei einem gewissen Zeitpunkt wird der Kabel- oder Mantelfehler überschritten, wodurch sich die Polarität des Messsignals ändert (nach unten zeigende Pfeile in Fig. 2). Es wird dann ein Signal (beispielsweise optisch oder akustisch) ausgegeben, welches anzeigt, dass der Kabelfehler überschritten wurde. So kann eine Richtungsanzeige realisiert werden.

Der Benutzer 25 kann dann im Nahbereich 35 des Kabel- oder Mantelfehlers die genaue Lage desselben durch kleinere Veränderungen der Elektrodenposition bestimmen.

In anderen Worten zeigen die Pfeile des ersten Bereichs 26 entlang der x-Achse des ersten Diagramms 21 die Messsignale 4, welche an unterschiedlichen Positionen 31 an unterschiedlichen Zeitpunkten mittels der zumindest zwei Elektroden 6 entgegengenommen wurden, wobei der Spannungspegel an jeder Position 31 eine andere Höhe aufweist, wodurch sich insgesamt ein erster Graph 33 mit positiver Polarität und ein zweiter Graph 34 mit negativer Polarität ergeben.

In Fig. 2 ist dementsprechend ein erster Bereich 26 mit positiver Polarität und ein zweiter Bereich 27 mit negativer Polarität zu sehen.

Mit dem Bezugszeichen 31 sind allgemein die Positionen 31 bezeichnet, an denen die Messungen durchgeführt werden.

In Fig. 2 ist zu sehen, dass der erste Graph 33 und der zweite Graph 34 an der Position 31 des Kabelfehlers 2 und /oder des Mantelfehlers 3 die x-Achse schneiden, weil sich bei einer genau symmetrischen Position der Elektroden über dem Kabel- oder Mantelfehler natürlich keine Potenzialdifferenz und somit kein Spannungspegel ergibt. Das ist auch der Mechanismus, der ausgenutzt wird, um im Nahbereich 35 die präzise Position des Kabel- oder Mantelfehlers zu bestimmen.

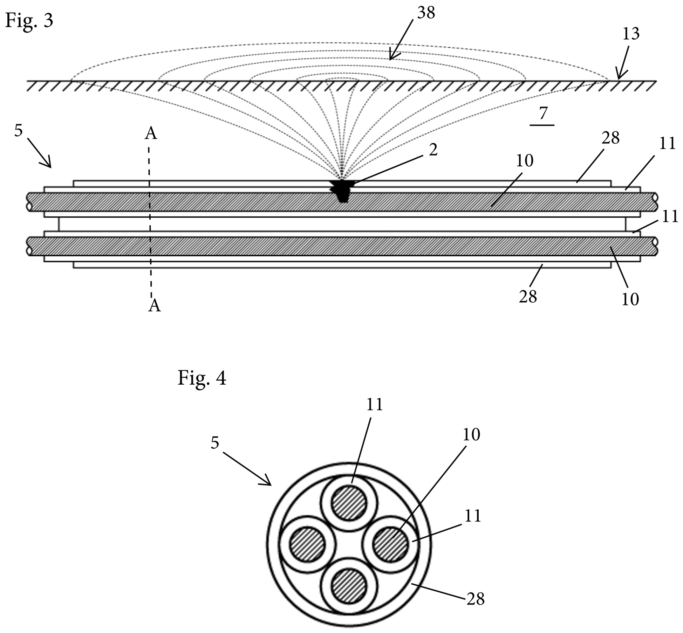

Fig.3 zeigt einen Kabelfehler 2, welche auch als Erdschluss bezeichnet werden kann, des Kabels 5 in einem ersten Ausführungsbeispiel eines Niederspannungskabels.

Fig. 3 zeigt, dass bei einem Kabelfehler 2 ein Leiter 10 mit dem Erdreich 7 in Kontakt steht.

Der Kabelfehler 2 in Fig. 3 zeigt eine Zerstörung des Kabelmantels 28 und der Isolation 11 (hier: Aderisolation).

Fig. 4 zeigt eine Schnittdarstellung des Kabels 5 gem. Fig. 3 im Schnitt A-A.

In Fig. 4 sind die Leiter 10 mit der jeweiligen Isolation 11 und dem Kabelmantel 28 gezeigt. Es kann sich beim Kabel 5 in Fig. 4 um ein Niederspannungskabel, bevorzugt um ein ungeschirmtes Niederspannungskabel, handeln.

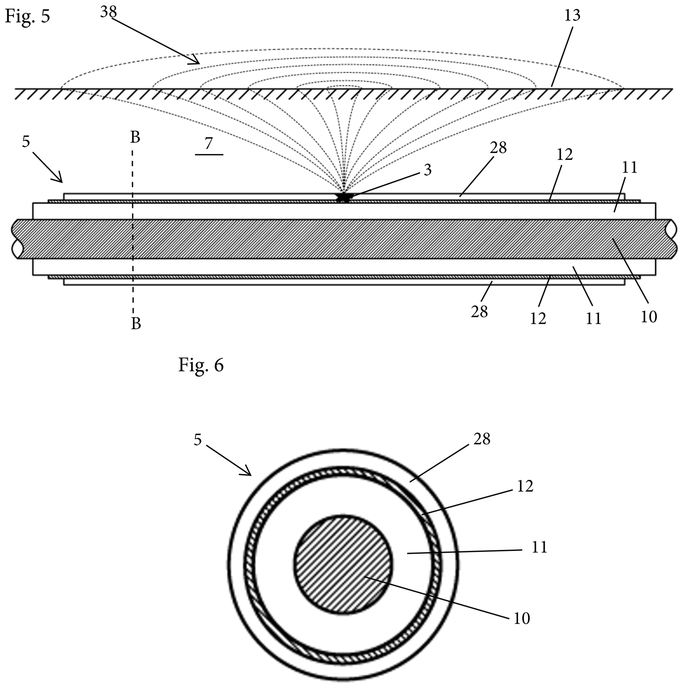

Fig. 5 zeigt ein zweites Ausführungsbeispiel, nämlich einen Mantelfehler 3 des Kabels 5, hier ein Mittelspannungskabel oder ein Hochspannungskabel mit einem Kabelschirm 12. Bei einem Mantelfehler 3 kann der Kabelmantel 28 des Kabels 5 bis zum Kabelschirm 12 beschädigt sein. Im Kabelschirm 12 induzierte Ströme resultieren hier ebenfalls in einem Schrittspannungstrichter.

Um einen Mantelfehler 3 zu detektieren kann das Messgerät 1 ein Mantelfehlerortungsgerät sein.

Fig. 6 zeigt eine Schnittdarstellung des Kabels 5 gem. Fig. 5 im Schnitt B-B.

Fig. 6 zeigt ein Kabel 5, bevorzugt kann das Kabel 5 in Fig. 6 ein Mittelspannungskabel oder Hochspannungskabel sein.

Das Kabel 5 in Fig. 6 umfasst einen Leiter 10, der von einer Isolation 11 (hier: Aderisolation) umgeben ist. Die Isolation 11 ist vom Kabelschirm 12 und vom Kabelmantel 28 ummantelt.

Fig. 7 zeigt ein zweites Diagramm 24. Die Bezeichnung der x-Achse beziehungsweise der y-Achse des zweiten Diagramms 24 entsprechen jenen des ersten Diagramms 21, welches in Fig. 2 abgebildet ist.

Fig. 7 zeigt ein zweites Diagramm 24 mit einer Richtungsanzeige, welche durch eine erste Richtung 22 und eine zweite Richtung 23 veranschaulicht ist. Jedes Messsignal 4 gibt durch die Synchronisation und die Zuweisung der Polarität eine der Richtungen 22, 23 an, welche zum Kabelfehler 2 oder Mantelfehler 3 führen.

In Fig. 7 ist zu erkennen, dass zwischen positiven und negativen Messungen, insbesondere positiven Halbwellen 36 und negativen Halbwellen 37 (siehe Fig. 11), unterschieden wird.

Eine Differenzierung der positiven Halbwellen 36 und der negativen Halbewellen 37 ist in diesem Ausführungsbeispiel für die Richtungsanzeige, insbesondere für die Ausgabe der ersten Richtung 22 und/oder zweiten Richtung 23, wichtig.

Fig. 8 zeigt ein viertes Diagramm 30. Die Bezeichnungen der x-Achse und der y-Achse entspricht jenen des ersten Diagramms 21.

Fig. 8 zeigt die Schrittspannungssignale ohne Synchronisierung, sodass keine Differenzierung zwischen positiven Halbwellen 36 und negativen Halbwellen 37 gegeben ist und somit auch keine Richtungsanzeige erfolgen kann.

Fig. 9 zeigt eine schematische Darstellung in Form eines Blockschaltbilds hinsichtlich der Signalverarbeitung.

Das mittels dem Schrittspannungssensor 14 erfasste (erste, zweite, weitere) Messsignal 4 wird zunächst einem Eingangsverstärker 15 und weiters einer Signalverarbeitung 16 zugeführt. Das so verarbeitete Signal wird einerseits der Synchronisationseinheit 17 zugeführt, um das Synchronisationssignal 8 zu erzeugen oder anzupassen. Hier erfolgt auch die fortlaufende Nachjustierung des Synchronisationssignals bei driftender Frequenz. Andererseits wird das verarbeitete Signal wie auch das Synchronisationssignal 8 der Richtungserkennung 18 zugeführt, welche die Richtung durch die beschrieben synchrone Auswertung des Messsignals 4 mit dem Synchronisationssignal 8 erkennt. Je nach Polarität ergibt sich, dass der Kabel- oder Mantelfehler überschritten wurde oder nicht. Die Ausgabe 19 ist die Richtungsanzeige und Anzeige der Signalstärke und Verlaufshistorie, sodass diese Information dann den Benutzer 25 erreicht.

Die Signalverarbeitung 16 kann an und für sich wie im Stand der Technik bekannt ausgeführt sein.

Erfindungsgemäß besteht der Schrittspannungssenor 14 aus zumindest zwei Elektroden 6.

In einem weiteren Ausführungsbeispiel kann der Schrittspannungssensor 14 ein A-Rahmen sein.

Es ist denkbar, dass der Eingangsverstärker 15 zur Signalverstärkung und/oder als Frequenzfiltereinrichtung und/oder als Wechselstromkopplungseinrichtung und /oder zur Gleichspannungserfassung und Kompensierung und/oder als Verzögerungseinrichtung verwendet werden kann und/oder zumindest eine dieser Einrichtungen umfasst.

Der Eingangsverstärker 15 kann einen Instrumentenverstärker und/oder einen Operationsverstärker und/oder Präzisionsverstärker umfassen.

Wie bereits im Zuge der Beschreibung erwähnt, kann der Frequenzfilter für eine Störsignalunterdrückung verwendet werden.

Ebenso kann ein vorbestimmte Phasenwinkelprofil verwendet werden, um nur die Messsignale mittels des Eingangsverstärker 15 zu verstärken.

Es kann sein, dass viele Messsignale 4 einen störenden Gleichspannungsanteil (DC) enthalten, der für die Analyse von Wechselspannung nicht relevant ist. Hierfür erfolgt ein Entfernen von Gleichspannungsanteilen (DC), sodass diese unterdrückt werden (DC-Offset).

Es kann auch sein, dass der Frequenzfilter auch die transiente Störung unterdrücken kann.

Es kann sein, dass kurzzeitig auftretende, exponentiell abklingende transiente Störungen, die beispielsweise durch Potentialdifferenzen aufgrund des zeitlich versetzten Einstechens der zumindest zwei Elektroden 6 verursacht werden, erkannt und/oder bewertet werden.

Eine Verzögerungseinrichtung, kann diese Störungen im gemessenen Betrag korrigieren.

Fig. 10 zeigt ein Messsignal 4. Das periodische Messsignal 4 kann ein Schrittspannungssignal 20 umfassen.

Das Messsignal 4 beginnt in diesem Ausführungsbeispiel mit einer positiven Halbwelle 36 und darauf folgt die analoge negative Halbwelle.

Fig 11 zeigt ein Beispiel einer Auswertung der Messsignale mit Synchronisierung vor und nach der Fehlerstelle. Durch die Synchronisierung erfolgt eine zeitgenaue Zuweisung und Ausrichtung der Polarität der empfangenen Messsignale 4.

Fig. 11 zeigt ein viertes Diagramm 30. Das vierte Diagramm 30 ist eine Detailansicht des Bereichs 38a der Fig. 7.

Fig. 11 zeigt, dass das Synchronisationssignal 8 ebenso positive Synchronisationssignalhalbwellen 36a und negative Synchronisationssignalhalbwellen 37a umfasst.

Dies kann wie in Fig.11 Signal 8 beispielhaft dargestellt als Rechtecksignal ausgeführt werden, kann aber auch durch andere Signalformen erfolgen.

In Fig. 11 zeigt ein Beispiel, wie die negativen Halbwellen 36 und/oder die positiven Halbwellen 37 des Messsignals 4, 20 auf Basis des Synchronisationssignals 8 ausgewertet werden.

Die Spannungszeitfläche 39, 40 wird beziehungsweise werden hierbei jeweils einer positiven Halbwelle 36 beziehungsweise negativen Halbwelle 37 zugeordnet.

Dadurch ergeben sich Messsignale 4 mit positiven Halbwellen 36 und negativen Halbwellen 37, wobei mehrere, insbesondere zumindest zwei, positive Halbwellen 36 beziehungsweise negative Halbwellen 37 auch als positive Spannungszeitfläche 39 beziehungsweise negative Spannungszeitfläche 40 bezeichnet werden können.

Bevorzugt kann es sein, dass beide Halbwellen 36, 37 von der Wechselspannung verwendet werden.

Erfindungsgemäß werden die Messsignale 4 mit dem Synchronisationssignal 8 abgeglichen.

Der Vollständigkeit halber wird erwähnt, dass alle Halbwellen mit gerader Zahl als positive Halbwelle 36 definiert werden und alle Halbwellen mit ungerader Zahl als negative Halbwellen 37 definiert werden. Es ist denkbar, dass dies in umgekehrter Reihenfolge sein kann.

Um eine Richtungserkennung zu erhalten, ist es denkbar, dass nur eine der Halbwellen 36, 37, also jede 2 Halbwelle entweder die positiven Halbwellen 36 oder die negativen Halbwellen 37, verwendet werden.

Besonders bevorzugt werden für die Richtungserkennung beide Halbwellen 36, 37 verwendet.

Es ist in Fig. 11 gezeigt, dass die positiven Halbwellen 36 und die negativen Halbwellen 37 in ihrer Logik abgeglichen und zugeordnet werden.

Fig. 11 zeigt, dass für die Richtungserkennung die Spannungszeitflächen 39,40 jeweils zumindest zwei Halbwellen 36, 37 umfassen, wobei jede der Halbwellen 36, 37 eine definierte Halbwellenbreite im Bereich von 0 bis 180 Grad aufweist.

In Fig. 11 ist die erste Halbwelle des Signals links des Mantel- oder Kabelfehlers 2, 3 eine positive Halbwelle 36, während die erste Halbwelle des Signals rechts des Mantel- oder Kabelfehlers 2, 3 eine negative Halbwelle 37 ist.

Das ebenfalls symbolisch dargestellte Synchronisationssignal 8 weist ebenfalls positive Synchronisationssignalhalbwellen 36a und negative Synchronisationssignalhalbwellen 37a auf.

Das Schrittspannungssignal (Messsignal 4) aus Fig. 11 wird mit dem Synchronisationssignal 8 aufbereitet, nämlich indem diejenigen Halbwellen umgeklappt werden (d.h. mit einem Minus versehen werden), bei denen zeitgleich eine positive Synchronisationssignalhalbwelle 36a vorliegt. Diejenigen Halbwellen, bei denen zeitgleich eine negative Synchronisationssignalhalbwelle 37a vorliegt, werden nicht umgeklappt.

Damit ergeben sich generierte positive Halbwellen 42 und generierte negative Halbwellen 41.

Wie aus Fig. 11 ersichtlich ist, ergibt sich damit jeweils eine definierte Polarität des Signals 4, nämlich im vorliegenden Beispiel eine positive Polarität links des Kabel- oder Mantelfehlers 2,3 und eine negative Polarität rechts des Kabel- oder Mantelfehlers 2,3.

Auf dieser Basis kann jeweils die erste Richtung 22 oder die zweite Richtung 23 dem Messsignal 4 zugewiesen und für den Benutzer 25 ausgegeben werden.

Die Messung kann durch Verwendung einer Halbwelle erfolgen, als Beispiel die erste Halbwelle berichtigt durch die Synchronisation.

Vorteilhaft werden in anderen bevorzugten Ausführungsbeispielen beide Halbwellen der (ersten, zweiten, weiteren) Messsignale 4 verwendet, dabei verdoppelt sich die Spannungszeitfläche 39, 40 und auch das Messsignal 4.

Die generierte negative Halbwelle 41 und/oder eine generierte positive Halbwelle 42 können für die Detektion des Kabelfehlers 2 und/oder Mantelfehlers 3 ausschlaggebend sein.

Es ist denkbar, dass durch die Logik der durch die Synchronisation gegebenenfalls korrigierten Halbwellen, vorzugsweise automatisch, eine Annäherung zum Kabelfehler 2 und/oder Mantelfehler 3 und/oder eine Entfernung vom Kabelfehler 2 und/oder Mantelfehler 3 weg, erkannt wird.

Es ist auch denkbar Fehlsignale durch Erdungsbänder und andere metallische Leitungen durch die Synchronisierung zu erkennen und damit ein vermeintliches Nullsignal nicht als Fehler zu werten.

Zusammenfassen ausgedrückt, wird mit dem in Verbindung mit Fig. 11 beschriebenen Ausführungsbeispiel durch synchrones Auswerten des (zweiten oder weiteren) Messsignals mit dem Synchronisationssignal bestimmt, ob das jeweilige Messsignal 4 im Wesentlichen in Phase oder gegenphasig mit dem Synchronisationssignal 8 ist. Im ersten Fall (in Phase) wurde der Kabel- oder Mantelfehler noch nicht überschritten, im zweiten Fall (gegenphasig) schon.

Natürlich sind auch Ausführungen denkbar, wobei das Synchronisationssignal 8 beispielsweise gegenphasig mit dem ersten Messsignal 4 erzeugt wird und auf das Überschreiten des Kabel- oder Mantelfehlers geschlossen wird, wenn das Synchronisationssignal 8 gleichphasig mit dem zweiten oder weiteren Messsignal 4 ist.

Die vorliegende Erfindung kann auch wie folgt beschrieben werden:
1. Messgerät (1) zum Detektieren von durch einen Kabelfehler (2) und/oder Mantelfehler (3) hervorgerufenen Messsignalen (4) in der Umgebung des Kabels (5), wobei das Messgerät (1) zumindest zwei Elektroden (6) umfasst, welche dazu ausgebildet sind, die Messsignale (4), vorzugsweise direkt im Erdbereich (7), abzunehmen, gekennzeichnet dadurch, dass das Messgerät (1) zum Ausführen der folgenden Funktionen ausgebildet ist:
   - Entgegennehmen eines, vorzugsweise mittels der zumindest zwei Elektroden (6) abgenommenen, ersten Messsignals (4a) und
   - Generieren eines Synchronisationssignals (8), welches mit dem ersten Messsignal (4a) zeitlich und/oder in einer Phasenlage synchron ist, und
   - Auswerten eines mittels der Elektroden (6) abgenommenen zweiten Messsignals (4b) und/oder nachfolgenden Messsignals (4c) synchron mit dem Synchronisationssignal (8).
2. Messgerät (1) nach Satz 1, wobei das Messgerät (1) dazu ausgebildet ist, mehr als ein Viertel, bevorzugt mehr als die Hälfte, bevorzugt 3/4, besonders bevorzugt mehr als 90% einer Vollperiode des ersten periodischen Messsignals (4a) und/oder des zweiten periodischen Messsignals (4b), vorzugsweise aller periodischer Messsignale, auszuwerten.
3. Messgerät (1) nach wenigstens einem der vorangehenden Sätze, wobei das erste Messsignal (4a) und/oder das zweite Messsignal (4b), vorzugsweise alle Messsignale (4c), eine Spannung und/oder eine Stromstärke umfasst beziehungsweise umfassen.
4. Messgerät (1) nach wenigstens einem der vorangehenden Sätze, wobei das Messgerät (1) dazu ausgebildet ist, die Wechselspannung und/oder die Frequenz des ersten Messsignals (4a) und/oder des zweiten Messsignals (4b) und/oder nachfolgenden Messsignals (4c), vorzugsweise aller Messsignale, zu ermitteln.
5. Messgerät (1) nach wenigstens einem der vorangehenden Sätze, wobei das Messgerät (1) dazu ausgebildet ist, das Synchronisationssignal (8) kontinuierlich weiter zu generieren, falls das Messsignal (4) unterbrochen wird.
6. Messgerät (1) nach wenigstens einem der vorangehenden Sätze, wobei das Messgerät (1) dazu ausgebildet ist, das Synchronisationssignal mit dem ersten Messsignal (4a) und/oder dem zweiten Messsignal (4b) und/oder dem nachfolgenden Messsignal (4c), vorzugsweise mit allen Messsignalen, hinsichtlich der Phasenlage und/oder der Frequenz und/oder des Spannungspegels (9) zu synchronisieren, vorzugsweise unter Verwendung einer kontinuierlichen Frequenzüberwachung und/oder einer automatischen Frequenznachführung.
7. Messgerät (1) nach wenigstens einem der vorangehenden Sätze, wobei das Messgerät (1) dazu ausgebildet ist, einen erhaltenen zweiten Betrag eines Spannungspegels (9) des detektierten zweiten Messsignals (4b) mit einem erhaltenen ersten Betrag eines ersten Spannungspegels (9) des detektierten ersten Messsignals (4a) zu vergleichen.
8. Messgerät (1) nach wenigstens einem der vorangehenden Sätze, wobei das Messgerät (1) dazu ausgebildet ist, eine Polaritätsumkehr zwischen dem ersten Messsignal (4a) und zweiten Messsignal (4b) und/oder nachfolgenden Messsignals (4c), vorzugsweise zwischen allen Messsignalen, zu erfassen.
9. Messgerät (1) nach wenigstens einem der vorangehenden Sätze, wobei das Messgerät (1) dazu ausgebildet ist, einen höheren Betrag des Spannungspegels (9) des zweiten Messsignals (4b) zum Betrag des Spannungspegels (9) des detektierten ersten Messsignals (4a), bevorzugt unter Berücksichtigung der Phasenlage, zu vergleichen und/oder zu interpretieren, dass der Kabelfehler (2) und/oder der Mantelfehler (3), während der Messung des zweiten Messsignals (4b) näher an den zumindest zwei Elektroden (6) gelegen ist als bei der Messung des ersten Messsignals (4a).
10. Messgerät (1) nach wenigstens einem der vorangehenden Sätze, wobei das Messgerät (1) dazu ausgebildet ist, die erhaltenen Messdaten des ersten Messsignals (4a) und/oder des zweiten Messsignals (4b) und/oder nachfolgenden Messsignals (4c), vorzugsweise aller Messsignale, und/oder einen Spannungspegel und/oder eine Richtungsangabe visuell oder akustisch auszugeben.
11. Messgerät (1) nach wenigstens einem der vorangehenden Sätze, wobei das Messgerät (1) dazu ausgebildet ist, während der Messung des ersten Messsignals (4a) und/oder zweiten Messsignals (4b) und/oder nachfolgenden Messsignals (4c), vorzugsweise aller Messsignale, die Koordinaten mittels GPS-Ortung festzustellen.
12. Messgerät (1) nach Satz 11, wobei das Messgerät (1) dazu ausgebildet ist, die mittels GPS-Ortung erhaltenen Koordinaten, vorzugsweise automatisch, in ein kartographisches System zu übertragen.
13. Messgerät (1) zum Detektieren von durch einen Kabelfehler (2) und/oder Mantelfehler (3) hervorgerufenen Messsignalen (4) in der Umgebung des Kabels (5), bevorzugt nach einem der vorhergehenden Ansprüche, wobei das Messgerät (1) zumindest zwei Elektroden (6) umfasst, welche dazu ausgebildet sind, die Messsignale (4), vorzugsweise direkt im Erdbereich (7), abzunehmen, dadurch gekennzeichnet, dass zusätzlich eine Referenzelektrode vorgesehen ist und das Messgerät zum Ausführen der folgenden Funktionen ausgebildet ist:
   - Entgegennehmen eines mittels der Referenzelektrode abgenommenen Referenzsignals und
   - Auswerten eines mittels der zumindest zwei Elektroden (6) abgenommenen Messsignals und/oder nachfolgenden Messsignals synchron mit dem Referenzsignal.
14. Messgerät (1) nach Satz 13, wobei das Messgerät dazu ausgebildet ist, die Potentialdifferenz zwischen zumindest einer der zwei Elektroden (6) und der Referenzelektrode zu ermitteln.
15. Verfahren zum Detektieren von durch einen Kabelfehler (2) und/oder Mantelfehler (3) hervorgerufenen Messsignalen (4) in der Umgebung des Kabels (5), bevorzugt mittels eines Messgeräts (1) nach einem der Sätze 1 bis 14, umfassend die nachfolgenden Schritte:
   - Aufnehmen eines, vorzugsweise mittels der zumindest zwei Elektroden (6) abgenommenen, ersten Messsignals und
   - Generieren eines Synchronisationssignals (8), welches mit dem ersten Messsignal (4a) zeitlich synchron ist und
   - Auswerten eines mittels der zumindest zwei Elektroden (6) abgenommenen zweiten Messsignals (4b) und/oder nachfolgenden Messsignals synchron mit dem Synchronisationssignal (8).
16. Verfahren zum Detektieren von durch einen Kabelfehler (2) und/oder Mantelfehler (3) hervorgerufenen Messsignalen (4) in der Umgebung des Kabels (5), bevorzugt mittels eines Messgeräts (1) nach einem der Sätze 1 bis 15, umfassend die nachfolgenden Schritte:
   - Entgegennehmen eines mittels der Referenzelektrode abgenommenen Referenzsignals und
   - Auswerten eines mittels der zumindest zwei Elektroden (6) abgenommenen Messsignals und/oder nachfolgenden Messsignals synchron mit dem Referenzsignal.
17. Verfahren nach wenigstens einem der Sätze 15 oder 16, wobei zumindest einer der Schritte, bevorzugt alle der Schritte, wiederholt werden, falls eine Messung nicht erfolgreich war.
18. Verfahren nach Sätze 15 bis 17, wobei zum Detektieren von jedem weiteren Messsignal alle der Schritte zu wiederholen sind.
19. Verfahren nach wenigstens einem der Sätze 15 bis 18, wobei das Messgerät (1) dazu ausgebildet ist, das erste Messsignal (4a) und/oder das zweite Messsignal (4b) und/oder nachfolgenden Messsignal (4c), vorzugsweise alle Messsignale, zeitversetzt und/oder ortsversetzt mittels der zumindest zwei Elektroden (6) zu detektieren.
20. Verwendung eines Messgeräts (1) nach wenigstens einem der Sätze 1 bis 14 bei einem Verfahren nach einem der Sätze 15 bis 19.
21. Computerprogrammprodukt, umfassend Befehle, die bei der Ausführung des Programms durch Computer diesen veranlassen, folgendes durchzuführen:
   - Entgegennehmen eines, vorzugsweise mittels der zumindest zwei Elektroden (6) abgenommenen, ersten Messsignals (4a) und
   - Generieren eines Synchronisationssignals (8), welches mit dem ersten Messsignal (4a) zeitlich und/oder in einer Phasenlage synchron ist, und
   - Auswerten eines mittels der zumindest zwei Elektroden (6) abgenommenen zweiten Messsignals (4b) und/oder nachfolgenden Messsignals (4c) synchron mit dem Synchronisationssignal (8).
22. Computerprogrammprodukt, insbesondere gemäß Satz 21, umfassend Befehle, die bei der Ausführung des Programms durch Computer diesen veranlassen, folgendes durchzuführen:
   - Entgegennehmen eines mittels der Referenzelektrode abgenommenen Referenzsignals und
   - Auswerten eines mittels der zumindest zwei Elektroden (6) abgenommenen Messsignals und/oder nachfolgenden Messsignals synchron mit dem Referenzsignal.
23. Transitorisches oder nicht transitorisches computerlesbares Speichermedium auf dem das Computerprogrammprodukt nach Satz 21 und 22 gespeichert ist.

### Bezugszeichenliste:

| | | | |
|---|---|---|---|
| 1 | Messgerät | 24 | Zweites Diagramm |
| 2 | Kabelfehler | 25 | Benutzer |
| 3 | Mantelfehler | 26 | Erster Bereich |
| 4 | Messsignale | 27 | Zweiter Bereich |
| 4a | Erstes Messsignal | 28 | Kabelmantel |
| 4b | Zweites Messsignal | 29 | Drittes Diagramm |
| 4c | Nachfolgendes Messsignal | 30 | Viertes Diagramm |
| | | 31 | Position |
| 5 | Kabel | 32 | Verbindungskabel |
| 6 | Elektroden | 33 | Erster Graph |
| 7 | Erdreich | 34 | Zweiter Graph |
| 8 | Synchronisationssignal | 35 | Nahbereich |
| | | 36 | Positive Halbwelle |
| 9 | Spannungspegel | 36a | Positive Synchronisationssignalhalbwelle |
| 10 | Leiter | | |
| 11 | Isolation | | |
| 12 | Kabelschirm | 37 | Negative Halbwelle |
| 13 | Erdoberfläche | 37a | Negative Synchronisationssignalhalbwelle |
| 14 | Schrittspannungssensor | | |
| 15 | Eingangsverstärker | 38 | Schrittspannungstrichter |
| 16 | Signalverarbeitung | | |
| 17 | Synchronisierung | 38a | Bereich |
| 18 | Richtungserkennungsv ektor | 39 | Positive Spannungszeitfläche |
| 19 | Ausgabe | 40 | Negative Spannungszeitfläche |
| 20 | Schrittspannungssignal | | |
| | | 41 | Generierte negative Halbwelle |
| 21 | Erstes Diagramm | | |
| 22 | Erste Richtung | 42 | Generierte positive Halbwelle |
| 23 | Zweite Richtung | | |

## Patentansprüche

1. Messgerät (1) zum Detektieren von durch einen Kabelfehler (2) und/oder Mantelfehler (3) hervorgerufenen Messsignalen (4) in der Umgebung des Kabels (5), wobei das Messgerät (1) zumindest zwei Elektroden (6) umfasst, welche dazu ausgebildet sind, die Messsignale (4), vorzugsweise direkt im Erdbereich (7), abzunehmen, **gekennzeichnet dadurch, dass** das Messgerät (1) zum Ausführen der folgenden Funktionen ausgebildet ist:
- Entgegennehmen eines, vorzugsweise mittels der zumindest zwei Elektroden (6) abgenommenen, ersten Messsignals (4a) und
- Generieren eines Synchronisationssignals (8), welches mit dem ersten Messsignal (4a) zeitlich und/oder in einer Phasenlage synchron ist, und
- Auswerten eines mittels der Elektroden (6) abgenommenen zweiten Messsignals (4b) und/oder nachfolgenden Messsignals (4c) synchron mit dem Synchronisationssignal (8).

2. Messgerät (1) nach Anspruch 1, wobei das Messgerät (1) dazu ausgebildet ist, mehr als ein Viertel, bevorzugt mehr als die Hälfte, bevorzugt 3/4, besonders bevorzugt mehr als 90% einer Vollperiode des ersten periodischen Messsignals (4a) und/oder des zweiten periodischen Messsignals (4b), vorzugsweise aller periodischer Messsignale, auszuwerten.

3. Messgerät (1) nach wenigstens einem der vorangehenden Ansprüche, wobei das Messgerät (1) dazu ausgebildet ist, die Wechselspannung und/oder die Frequenz des ersten Messsignals (4a) und/oder des zweiten Messsignals (4b) und/oder nachfolgenden Messsignals (4c), vorzugsweise aller Messsignale, zu ermitteln.

4. Messgerät (1) nach wenigstens einem der vorangehenden Ansprüche, wobei das Messgerät (1) dazu ausgebildet ist, das Synchronisationssignal mit dem ersten Messsignal (4a) und/oder dem zweiten Messsignal (4b) und/oder dem nachfolgenden Messsignal (4c), vorzugsweise mit allen Messsignalen, hinsichtlich der Phasenlage und/oder der Frequenz und/oder des Spannungspegels (9) zu synchronisieren, vorzugsweise unter Verwendung einer kontinuierlichen Frequenzüberwachung und/oder einer automatischen Frequenznachführung.

5. Messgerät (1) nach wenigstens einem der vorangehenden Ansprüche, wobei das Messgerät (1) dazu ausgebildet ist, einen erhaltenen zweiten Betrag eines Spannungspegels (9) des detektierten zweiten Messsignals (4b) mit einem erhaltenen ersten Betrag eines ersten Spannungspegels (9) des detektierten ersten Messsignals (4a) zu vergleichen.

6. Messgerät (1) nach wenigstens einem der vorangehenden Ansprüche, wobei das Messgerät (1) dazu ausgebildet ist, eine Polaritätsumkehr zwischen dem ersten Messsignal (4a) und zweiten Messsignal (4b) und/oder nachfolgenden Messsignals (4c), vorzugsweise zwischen allen Messsignalen, zu erfassen.

7. Messgerät (1) nach wenigstens einem der vorangehenden Ansprüche, wobei das Messgerät (1) dazu ausgebildet ist, einen höheren Betrag des Spannungspegels (9) des zweiten Messsignals (4b) zum Betrag des Spannungspegels (9) des detektierten ersten Messsignals (4a), bevorzugt unter Berücksichtigung der Phasenlage, zu vergleichen und/oder zu interpretieren, dass der Kabelfehler (2) und/oder der Mantelfehler (3), während der Messung des zweiten Messsignals (4b) näher an den zumindest zwei Elektroden (6) gelegen ist als bei der Messung des ersten Messsignals (4a).

8. Messgerät (1) zum Detektieren von durch einen Kabelfehler (2) und/oder Mantelfehler (3) hervorgerufenen Messsignalen (4) in der Umgebung des Kabels (5), bevorzugt nach einem der vorhergehenden Ansprüche, wobei das Messgerät (1) zumindest zwei Elektroden (6) umfasst, welche dazu ausgebildet sind, die Messsignale (4), vorzugsweise direkt im Erdbereich (7), abzunehmen, **dadurch gekennzeichnet, dass** zusätzlich eine Referenzelektrode vorgesehen ist und das Messgerät zum Ausführen der folgenden Funktionen ausgebildet ist:
- Entgegennehmen eines mittels der Referenzelektrode abgenommenen Referenzsignals und
- Auswerten eines mittels der zumindest zwei Elektroden (6) abgenommenen Messsignals und/oder nachfolgenden Messsignals synchron mit dem Referenzsignal.

9. Verfahren zum Detektieren von durch einen Kabelfehler (2) und/oder Mantelfehler (3) hervorgerufenen Messsignalen (4) in der Umgebung des Kabels (5), bevorzugt mittels eines Messgeräts (1) nach einem der Ansprüche 1 bis 8, umfassend die nachfolgenden Schritte:
- Aufnehmen eines, vorzugsweise mittels der zumindest zwei Elektroden (6) abgenommenen, ersten Messsignals und
- Generieren eines Synchronisationssignals (8), welches mit dem ersten Messsignal (4a) zeitlich synchron ist und
- Auswerten eines mittels der zumindest zwei Elektroden (6) abgenommenen zweiten Messsignals (4b) und/oder nachfolgenden Messsignals synchron mit dem Synchronisationssignal (8).

10. Verfahren zum Detektieren von durch einen Kabelfehler (2) und/oder Mantelfehler (3) hervorgerufenen Messsignalen (4) in der Umgebung des Kabels (5), bevorzugt mittels eines Messgeräts (1) nach einem der Ansprüche 1 bis 9, umfassend die nachfolgenden Schritte:
- Entgegennehmen eines mittels der Referenzelektrode abgenommenen Referenzsignals und
- Auswerten eines mittels der zumindest zwei Elektroden (6) abgenommenen Messsignals und/oder nachfolgenden Messsignals synchron mit dem Referenzsignal.

11. Verfahren nach wenigstens einem der Ansprüche 9 oder 10 , wobei das Messgerät (1) dazu ausgebildet ist, das erste Messsignal (4a) und/oder das zweite Messsignal (4b) und/oder nachfolgenden Messsignal (4c), vorzugsweise alle Messsignale, zeitversetzt und/oder ortsversetzt mittels der zumindest zwei Elektroden (6) zu detektieren.

12. Verwendung eines Messgeräts (1) nach wenigstens einem der Ansprüche 1 bis 8 bei einem Verfahren nach einem der Ansprüche 9 bis 11.

13. Computerprogrammprodukt, umfassend Befehle, die bei der Ausführung des Programms durch Computer diesen veranlassen, folgendes durchzuführen:
- Entgegennehmen eines, vorzugsweise mittels der zumindest zwei Elektroden (6) abgenommenen, ersten Messsignals (4a) und
- Generieren eines Synchronisationssignals (8), welches mit dem ersten Messsignal (4a) zeitlich und/oder in einer Phasenlage synchron ist, und
- Auswerten eines mittels der zumindest zwei Elektroden (6) abgenommenen zweiten Messsignals (4b) und/oder nachfolgenden Messsignals (4c) synchron mit dem Synchronisationssignal (8).

14. Computerprogrammprodukt, insbesondere gemäß Anspruch 13, umfassend Befehle, die bei der Ausführung des Programms durch Computer diesen veranlassen, folgendes durchzuführen:
- Entgegennehmen eines mittels der Referenzelektrode abgenommenen Referenzsignals und
- Auswerten eines mittels der zumindest zwei Elektroden (6) abgenommenen Messsignals und/oder nachfolgenden Messsignals synchron mit dem Referenzsignal.

15. Transitorisches oder nicht transitorisches computerlesbares Speichermedium auf dem das Computerprogrammprodukt nach Anspruch 13 und 14 gespeichert ist.
